# EUROPEAN PATENT APPLICATION

(11) **EP 4 336 565 A1**
(43) Date of publication of application: **13.03.2024**
(21) Application number: 22918250.6
(22) Date of filing: 18.10.2022
(51) Int. Cl.: H01L 29/78, H01L 29/423, H01L 21/336

(54) **SILICON CARBIDE MOSFET DEVICE AND MANUFACTURING METHOD THEREFOR**

(30) Priority: 04.01.2022 CN 202210004474; 04.01.2022 CN 202220017322 U
(71) Applicant: Hubei Jiufengshan Laboratory, Wuhan, Hubei 430070 (CN)
(72) Inventor: YUAN, Jun, Wuhan, Hubei 430070 (CN)
(74) Representative: KASTEL Patentanwälte PartG mbB
(86) International application number: PCT/CN2022/125792
(87) International publication number: WO 2023/130798

(57) **Abstract**

Disclosed in the present application are a silicon carbide MOSFET device and a manufacturing method therefor. The silicon carbide MOSFET device comprises: an epitaxial wafer, which comprises a semiconductor substrate, and an epitaxial layer, which is arranged on a surface of the substrate; and a well region, a source region, and a trench gate electrode, which are arranged in the epitaxial layer. The trench gate electrode comprises a trench, which is located on a surface of the side of the epitaxial layer facing away from the substrate; and a gate electrode, which is located in the trench. The source region surrounds the trench, and is in contact with a side wall of the trench. The well region comprises: a first-layer well region, a second-layer well region, and a third-layer well region, which are sequentially arranged in the direction from the substrate to the source region, wherein the third-layer well region surrounds the trench, and is in contact with the side wall of the trench; a doped region is arranged in the epitaxial layer below the trench, and the first-layer well region surrounds the doped region, and is in contact with the doped region; part of the epitaxial layer is arranged between the first-layer well region and the third-layer well region, and the second-layer well region is located on two sides of the part of the epitaxial layer; and the part of the epitaxial layer is internally provided with a masking layer, which is used for protecting the bottom of the trench gate electrode; and the masking layer is located below the trench.

## Description

This application claims priority to Chinese Patent Application No. 202210004474.8, titled "SILICON CARBIDE MOSFET DEVICE AND METHOD FOR MANUFACTURING THE SAME" filed on January 04, 2022, and Chinese Patent Application No. 202220017322.7, titled "SILICON CARBIDE MOSFET DEVICE" filed on January 04, 2022, with the China National Intellectual Property Administration, which are incorporated herein by reference in its entirety.

### FIELD

The present disclosure relates to the technical field of semiconductor devices, and in particular to a silicon carbide (SiC) MOSFET device and a method for manufacturing the SiC MOSFET device.

### BACKGROUND

Continuous development of science and technology renders more and more electronic apparatuses widely applied in people's daily life and work. These electronic apparatuses engender great convenience, and are modern tools which are important and indispensable.

Integrated circuits are main structures for achieving various functions in the electronic apparatuses, and MOSFET devices are important electronic components in the integrated circuits. Silicon carbide MOSFET devices have become a major trend in the field due to their excellent characteristics in high-power applications.

Conventional silicon carbide MOSFET devices are still unsatisfactory. It is necessary to optimize their structures and manufacturing methods, in order to improve their performances.

### SUMMARY

In view of the above, a silicon carbide MOSFET device and a method for manufacturing the same are provided according to embodiments of the present disclosure. Technical solutions are as follows.

A silicon carbide MOSFET device is provided according to embodiments of the present disclosure. The silicon carbide MOSFET device comprises: an epitaxial wafer, which comprises a semiconductor substrate and epitaxial layers disposed on a surface of the semiconductor substrate; and a well region, a source region, and a trench gate, which are in the epitaxial layers; where: the trench gate comprises a gate disposed in a trench at a surface of the epitaxial layers facing away from the semiconductor substrate, and a gate dielectric layer is disposed between the gate electrode and the trench; the source region surrounds the trench and is in contact with sidewalls of the trench; the well region comprises a first layer, a second layer, and a third layer, which are arranged in the above-listed sequence along a direction pointing from the semiconductor substrate to the source region; a bottom of the trench is disposed higher than the first layer and lower than the third layer; the third layer surrounds the trench and is in contact with the sidewalls of the trench; one or more doped regions are disposed in the epitaxial layers and beneath the trench, and the first layer surrounds each of the one or more doped region and is in contact with said doped region; a part of the epitaxial layers is disposed between the first layer and the third layer, and the second layer is disposed on two sides of the part of the epitaxial layers; a shielding layer is disposed in the part of the epitaxial layers and is configured to protect a bottom of the trench gate; the shielding layer is disposed beneath the trench, and dopants in the shielding layer has a same polarity as dopants in each of the first layer, the second layer, and the third layer.

In an embodiment, a vertical projection of the one or more doped regions on the semiconductor substrate is located within a vertical projection of the trench on the semiconductor substrate, and the vertical projection of the trench on the semiconductor substrate is located within a vertical projection of the part of the epitaxial layers on the semiconductor substrate; and there is a non-zero distance between a boundary of the vertical projection of the trench and a boundary of the vertical projection of the part of the epitaxial layers.

In an embodiment, one or more connection regions, which connect the shielding layer and the first layer, are disposed in the part of the epitaxial layers, and dopants in each of the one or more connection region has the same polarity as the dopants in each of the first layer, the second layer, and the third layer.

In an embodiment, the first layer comprises: a first part and a second part, which are disposed at two sides, respectively, of the trench; where the one or more connection regions are multiple connection regions arranged sequentially along a first direction, which is parallel with the semiconductor substrate and parallel with an extending direction of the trench, and one or both of the first part and the second part are connected to the shielding layer via the multiple connection regions.

In an embodiment, the one or more doped regions are multiple doped regions arranged sequentially along a first direction, which is parallel with the semiconductor substrate and parallel with an extending direction of the trench.

In an embodiment, along a direction perpendicular to the semiconductor substrate, a distance from the shielding layer to the bottom of the trench is smaller than a distance from the shielding layer to the first layer.

In an embodiment, the shielding layer is in contact with the bottom of the trench.

In an embodiment, the second layer comprises a first part and a second part, which are disposed on two sides, respectively, of the trench, where the first part and the second part each is an integral structure.

In an embodiment, the second layer comprises a first part and a second part, which are disposed on two sides, respectively, of the trench; where the first part of the second layer and the second part each comprises multiple sub-regions arranged sequentially along a first direction, which is parallel with the semiconductor substrate and parallel with an extending direction of the trench, a current expanding region is disposed between each pair of sub-regions which are adjacent along the first direction among the multiple sub-regions, and dopants in the current expanding region has an opposite polarity to dopants in the multiple sub-regions.

In an embodiment, a polarity of dopants are identical among the first layer, the second layer, the third layer, the shielding layer, and the one or more connection regions, and a doping concentration of the one or more connection regions is greater than a doping concentration of each of the first layer, the second layer, and the third layer.

In an embodiment, each of the one or more connection regions extends at least from the bottom of the trench into the first layer; or a part of each of the one or more connection regions extends at least from the bottom of the trench into the first layer, and another part of said connection region extends at least from the surface of the epitaxial layers into the first layer along one of the sidewalls of the trench.

A method for manufacturing any foregoing silicon carbide MOSFET device is provided according to embodiments of the present disclosure. The method comprises: providing an epitaxial wafer, which comprises a semiconductor substrate and epitaxial layers disposed on a surface of the semiconductor substrate; forming a well region, a source region and a trench gate in the epitaxial layers; where: the trench gate comprises a gate disposed in a trench at a surface of the epitaxial layers facing away from the semiconductor substrate, and a gate dielectric layer is disposed between the gate electrode and the trench; the source region surrounds the trench and is in contact with sidewalls of the trench; the well region comprises a first layer, a second layer, and a third layer, which are arranged in the above-listed sequence along a direction pointing from the semiconductor substrate to the source region; a bottom of the trench is higher than the first layer and lower than the third layer; the third layer surrounds the trench and is in contact with the sidewalls of the trench; one or more doped regions are disposed in the epitaxial layers and beneath the trench, and the first layer surrounds each of the one or more doped region and is in contact with said doped region; a part of the epitaxial layers is disposed between the first layer and the third layer, and the second layer is disposed on two sides of the part of the epitaxial layers; a shielding layer is disposed in the part of the epitaxial layers and is configured to protect a bottom of the trench gate; the shielding layer is disposed beneath the trench, and dopants in the shielding layer has a same polarity as dopants in each of the first layer, the second layer, and the third layer.

In an embodiment, the epitaxial layers comprises: a first epitaxial layer disposed on the surface of the semiconductor substrate; a second epitaxial layer disposed on a surface of the first epitaxial layer facing away from the semiconductor substrate; and a third epitaxial layer on a surface of the second epitaxial layer facing away from the first epitaxial layer; where the second epitaxial layer comprises a to-be-implanted region and the first layer which surrounds the to-be-implanted region; and where forming the well region, the source region, and the trench gate in the epitaxial layers comprises: forming the source region, the second layer, and the third layer in a surface of the third epitaxial layer facing away from the semiconductor substrate; forming the trench in the surface of the third epitaxial layer facing away from the semiconductor substrate; forming the shielding layer and the doped region through the trench; forming a connection region, which connects the shielding layer and the first layer, through the trench; and forming the gate dielectric layer and the gate in the trench.

Therefore, the silicon carbide MOSFET device and the method for manufacturing the same are provided according to technical solutions of the present disclosure. The silicon carbide MOSFET device comprises: the epitaxial wafer, which comprises the semiconductor substrate and the epitaxial layers disposed on the surface of the semiconductor substrate; and the well region, the source region, and the trench gate, which are in the epitaxial layers. The trench gate comprises the gate disposed in the trench at the surface of the epitaxial layers facing away from the semiconductor substrate, and the gate dielectric layer is disposed between the gate electrode and the trench. The source region surrounds the trench and is in contact with the sidewalls of the trench. The well region comprises the first layer, the second layer, and the third layer, which are arranged in the above-listed sequence along the direction pointing from the semiconductor substrate to the source region. The bottom of the trench is disposed higher than the first layer and lower than the third layer. The third layer surrounds the trench and is in contact with the sidewalls of the trench. The one or more doped regions are disposed in the epitaxial layers and beneath the trench, and the first layer surrounds each of the one or more doped region and is in contact with such doped region. The part of the epitaxial layers is disposed between the first layer and the third layer, and the second layer is disposed on the two sides of the part of the epitaxial layers. The shielding layer is disposed in the part of the epitaxial layers and is configured to protect the bottom of the trench gate. The shielding layer is disposed beneath the trench, and the dopants in the shielding layer have the same polarity as the dopants in each of the first layer, the second layer, and the third layer.

### BRIEF DESCRIPTION OF THE DRAWINGS

In order to clarity illustration of the technical solutions according to embodiments of the present disclosure or conventional technology, hereinafter the drawings to be applied in embodiments of the present disclosure or technology are briefly described. Apparently, the drawings in the following descriptions are only some embodiments of the present disclosure, and other drawings may be obtained by those skilled in the art based on the provided drawings without creative efforts.

Structures, proportions, dimensions, and the like as shown in the drawings of this specification are intended for facilitating understanding and intelligibility for those skilled din the art in conjunction with content disclosed herein, not for limiting a condition of implementing the present disclosure, and hence do not represent practical techniques. Any structural modifications, changes in proportions, or adjustments in dimensions shall fall within the scope of the present disclosure as long as not affecting an effect or an objective of embodiments the present disclosure.
Figure 1 is a schematic structural diagram of a double-diffusion MOSFET (DMOSFET).
Figure 2 is a schematic structural diagram of a trench-gate MOSFET (UMOSFET).
Figure 3 is a waveform diagram of overshoot and oscillation in a voltage when switching a MOSFET between on and off.
Figure 4a is a schematic structural diagram of a silicon carbide MOSFET device according to an embodiment of the present disclosure.
Figure 4b is a schematic diagram of a main current path in a silicon carbide MOSFET device as shown in Figure 4a when switching on the MOSFET.
Figure 4c is a schematic diagram of equivalent parasitic parameters of a silicon carbide MOSFET device as shown in Figure 4b.
Figure 5 is a schematic structural diagram of a silicon carbide MOSFET device according to another embodiment of the present disclosure.
Figure 6 is a stereoscopic view of a silicon carbide MOSFET device according to an embodiment of the present disclosure.
Figure 7 is a top view of patterns for forming each layer of a well region, a trench, a doped region, and a connection region in a silicon carbide MOSFET device as shown in Figure 6.
Figure 8 is a view of a silicon carbide MOSFET device as shown in Figure 6 in a first cross section perpendicular to the extending direction of the trench.
Figure 9 is a view of a silicon carbide MOSFET device as shown in Figure 6 in a second cross section perpendicular to the extending direction of the trench.
Figure 10 is a stereoscopic view of a silicon carbide MOSFET device according to another embodiment of the present disclosure;
Figure 11 is a top view of patterns for forming each layer of a well region, a trench, a doped region, and a connection region in a silicon carbide MOSFET device as shown in Figure 10.
Figure 12 is a schematic structural diagram of a silicon carbide MOSFET device according to another embodiment of the present disclosure.
Figures 13 to 19 are schematic diagrams in a process of a method for manufacturing a silicon carbide MOSFET device according to an embodiment of the present disclosure.
Figure 20 is a pattern for forming a trench and an area of ion implantation for forming a doped region of a silicon carbide MOSFET device according to an embodiment of the present disclosure.

### DETAILED DESCRIPTION OF EMBODIMENTS

Hereinafter technical solutions in embodiments of the present disclosure are described clearly and completely in conjunction with the drawings in embodiments of the present closure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

Hereinafter the present disclosure is further illustrated in detail in conjunction with the drawings and specific embodiments, in order to elucidate and clarify objectives, features, and advantages of the present disclosure.

Silicon carbide (SiC) is quite appealing in high-power electronics due to its excellent properties, and has become an ideal material for power MOSFETs with high performances. In general, SiC-based vertical power MOSFET devices include lateral double-diffusion MOSFET (DMOSFET) and vertical trench-gate MOSFET (UMOSFET).

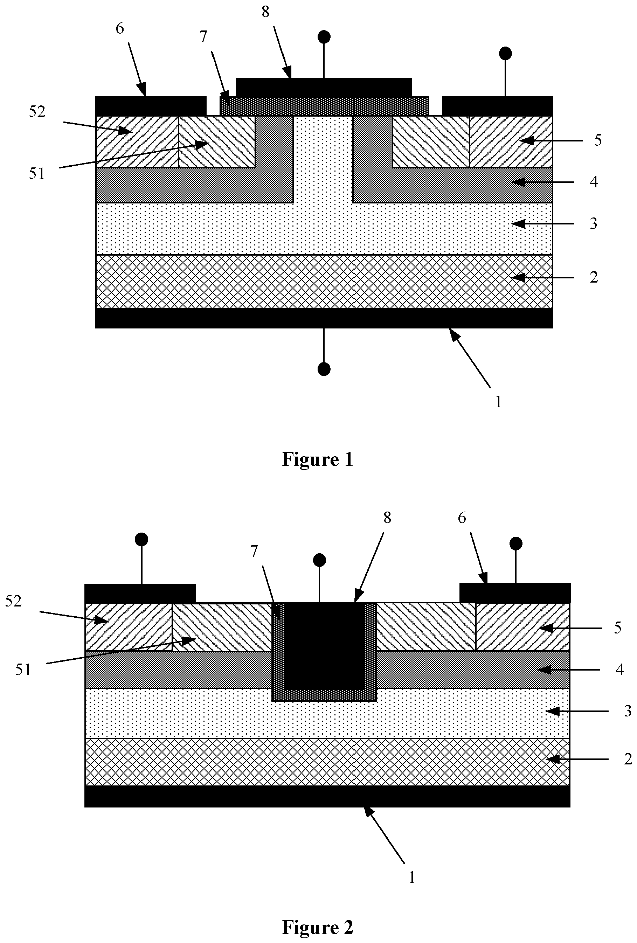

Reference is made to Figure 1, which is a schematic structural diagram of a DMOSFET. The DMOSFET comprises an n+ (heavily n doped) substrate 2, an n- (lightly n doped) drift region 3 disposed on a surface of the substrate 2, a p-type well region 4 disposed in the drift region 3, and a source region 5 disposed in the p-type well region. The source region 5 comprises an n+ doped region 51 and a p+ (heavily p doped) doped region 52. A gate dielectric layer 7 is disposed on a surface of the drift region 3, and a gate electrode 8 is disposed on a surface of the gate dielectric layer 7. A drain electrode 1 is located on a surface of the substrate 2 facing away from the drift region 3.

The DMOSFET structure adopts planar diffusion. A gate made of a refractory material such as polysilicon serves as a mask, and a p-type base region and an n+ source region are defined by an edge of the gate. The name "DMOS" origins from double diffusion, in which a surface channel region is formed by using a difference between lateral diffusion in the p-type base region and lateral diffusion in the n+ source region.

Reference is made to Figure 2, which is a schematic structural diagram of a UMOSFET. A difference from the structure as shown in Figure 1 is that a U-shaped trench is provided in the UMOSFET. A surface of the U-shaped trench is covered with a gate dielectric layer 7, and the U-shaped trench is filled with a gate electrode 8. The name "UMOSFET", which is vertical and has a trench gate, origins from the U-shaped trench. The U-shaped trench is formed in a gate region through reactive ion etching. The U-shaped trench allows a high channel density (where the channel density is defined by a width of a channel in an active region), such that the characteristic ON-state resistance of the device is significantly reduced.

Some manufacturers have already launched commercial products of planar SiC MOSFETs after years of research in the field. Modern Techniques for conventional lateral DMOSFETs has reached a point at the On-resistance of a MOS cell cannot be reduced with miniaturization of the MOS, mainly due to limitation of resistance in a JFET neck region. That is, it is hard to decrease the ON-resistance per unit area to 2mΩ·cm² even when decreasing a dimension of photolithography. Such issues can be effectively addressed by using the U-shaped trench structure as shown in Figure 2. The U-shaped trench structure utilizes trench etching techniques for manufacturing storage capacitors in memories, which turns a channel from horizontal to vertical. Compared with the conventional structures, the JFET neck resistance is eliminated, and a density of cells is greatly increased, which improves a capability of the power semiconductor in handling currents.

In conventional technology, the SiC-based UMOSFETs still have several problems in actual manufacturing and application.

First, a high electrical field in a drift region made of SiC results in a high electrical field on the gate dielectric layer. The problem is exacerbated at corners of the trench, and hence the gate dielectric layer is subject to rapid breakdown under a high drain voltage. Thereby, the UMOFETs have poor tolerance against harsh electrostatic environments and large voltage spikes in a circuit.

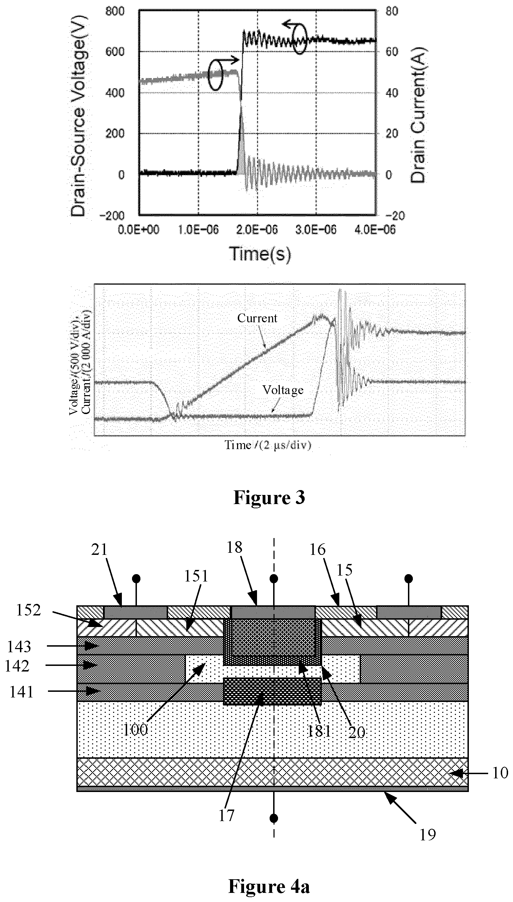

Second, SiC-based power MOSFETs are mainly applied to high-voltage, high-frequency, and large-current electronics, and hence parasitic parameters in a circuit may generate spikes and glitches during high-frequency switching. Reference is made to Figure 3, which shows a waveform diagram of overshoot and oscillation in a voltage when a MOSFET is switched between on and off. It can be seen from Figure 3 that an instantaneous overvoltage increases a loss due to the switching, and a large surge voltage is generated due to a change in a power load. Hence, anti-surge and overvoltage protection of the MOSFETs are very important.

Conventional MOSFET devices do not have a function of anti-surge and overvoltage protection. Hence, in practice, it is often necessary to provide a buffer circuit, a surge suppressing circuit, and an overvoltage protection circuit, which are complex. Such external matching circuits for suppression and overvoltage protection are often subject to a time delay. Accordingly, the high-frequency spike voltage surge is still directly borne by the device in practical switching, which sometimes results in breakdown of the channel region and gradual failure of the gate structure and ohmic-contact region of electrodes. That is, there would be reliability issues.

Third, a limited depth of ion implantation techniques makes it difficult to implement pertinent protective and anti-surge structures for the trench gate. Generally, a depth of the trench for forming the gate electrode is greater than 1µm or even 2µm. In practice, a buried protective structure, which is capable to protect the gate in the trench, cannot be fabricated directly through ion implantation, because a depth of ion implantation can hardly exceed 1µm in silicon carbide. Due to characteristics of silicon carbide, deep implantation requires injecting ions under energy high enough to damage a lattice of silicon carbide. In a case that a silicon carbide MOSFET device having a deep doped region is to be manufactured, a required doped region should be formed a readily made epitaxial layer through etching and ion implantation before subsequent epitaxial layer(s) are formed when fabricating an epitaxial wafer. Therefore, in conventional technology, a required doped region is first formed in a precedent epitaxial layer through etching and ion implantation, and then two p-type epitaxial layers having a specific structure are formed. Such manufacturing process is a complicated and costly.

Reference is made to Figure 4a, which is a schematic structural diagram of a silicon carbide MOSFET device according to an embodiment of the present disclosure. The silicon carbide MOSFET device comprises an epitaxial wafer, a well region, a source region 15, and a trench gate.

The epitaxial wafer comprises a semiconductor substrate 10 and epitaxial layers disposed on a surface of the semiconductor substrate 10.

The well region, the source region 15, and the trench gate are in the epitaxial layers.

The trench gate comprises a gate 18 disposed in a trench 20 at a surface of the epitaxial layers facing away from the semiconductor substrate. A gate dielectric layer 181 is disposed between the gate electrode and the trench.

The source region 15 surrounds the trench 20, and is in contact with sidewalls of the trench 20.

The well region comprises a first layer 141, a second layer 142, and a third layer 143, which are arranged in the above-listed sequence along a direction pointing from the semiconductor substrate 10 to the source region 15. A bottom of the trench 20 is disposed higher than the first layer 141 and lower than the third layer 143. The third layer 143 surrounds the 20 trench and is in contact with the sidewalls of the trench 20. Doped region(s) 17 are disposed in the epitaxial layers and beneath the trench 20. The first layer 141 surrounds each of the doped regions 17, and is in contact with such doped region 17. A part 100 of the epitaxial layers is disposed between the first layer 141 and the third layer 143, and the second layer 142 is disposed on two sides of the part 100 of the epitaxial layers.

A metallic drain electrode 19 is disposed on the semiconductor substrate 10 facing away from the epitaxial layers. The source region 15 comprises a first region 151 and a second region 152 which have dopants of opposite polarities. The first region 151 may be an n+ doped region and the second region 152 may be a p+ doped region. A metallic source electrode 21 is in contact with both the first region 151 and the second region 152. An insulating layer 16 is disposed on a surface of the source region 15, and the insulating layer 16 exposes the metallic source electrode 21 and the gate electrode 18. The gate 18 comprises a filling dielectric disposed within the trench 20 and a metallic gate electrode disposed on a surface of the filling dielectric.

As shown in Figure 4a, the well region comprises three layers, namely, the first layer 141, the second layer 142, and the third layer 14, in the silicon carbide MOSFET device. The uppermost layer, i.e., the third layer 143, is located on both left and right sides of the trench 20, and is in contact with the sidewalls of the trench 20. The middle layer, i.e., the second layer 142, comprises two parts located on the left side and the right side, respectively, of the trench 20, and is not in contact with the sidewalls of the trench 20. The lowermost layer, i.e., the first layer 141, is located beneath the trench 20, and is not in contact with the trench 20.

A distance between each of the left and right parts of the second layer 142 and a vertical central axis of the cell structure is greater than a distance between each of the left and right parts of the first layer 141 and the vertical central axis of the cell structure. In an embodiment, the vertical central axis of the cell structure is a central axis of the trench 20, as indicated by the dashed line in Figure 4a. That is, the first layer 141 is closer to the central axis than the second layer 142. The first layer 141 is closer to the sidewalls of the trench than the second layer 142, and hence can protect corners at the bottom of the trench 20 through forming a parasitic JFET, which is capable to suppress high-frequency oscillations and surges. The second layer 142 connects the first layer 141 to the source electrode, so that the first layer 141 can suppress the surges.

A JFET structure can be formed, through the doped region 17, on a current path between the source electrode and the drain electrode. Characteristics of an on-state of the JFET structure may be optimized and adjusted through a design of a pattern of the doped region 17 and a concentration of ions implanted into the doped region 17, so as to improve performances of the MOSFET device.

Herein a second epitaxial layer 12 and the doped region 17 penetrating the second epitaxial layer 12 are introduced into the epitaxial wafer, which addresses an issue of shielding a gate-oxide structure in SiC-based trench-gate MOSFETs and an issue of techniques for deep implantation in silicon carbide. Moreover, the doped region 17 introduces a JFET structure, which can be modulated through ion implantation, into the current path of the device. Hence, ON-resistance and self-locking protection of the MOSFET can be automatically adjusted while maintaining a small cell of the MOSFET.

The silicon carbide MOSFET device as shown in Figure 4a has at least following advantages.

In the silicon carbide MOSFET device, the JFET structure is introduced into the current path of the cell, which can automatically adjust the ON-resistance and the self-locking protection of the MOSFET while maintaining a smaller cell of the MOSFET. Moreover, the characteristics of the on-state of the JFET structure can be optimized and adjusted through the design of the pattern of the doped region 17, the concentration of ions implanted into the doped region 17, and a boundary of the pattern. Hence, the design and processing are flexible and manufacture-friendly.

The epitaxial wafer having a buried layer (i.e., the second epitaxial layer 12) and the JFET structure modulated through ions implanted into the doped region 17 are capable to expand depletion regions at two sides automatically, thereby increases the ON-resistance of the JFET structure, under a large surge voltage and hence are equivalent to a buffer circuit for suppressing surge spikes. Moreover, the depletion regions at the two sides continue to expand and overlap when the surge voltage is too large, which engenders a blocking effect and protects the gate dielectric layer located inside at a surface of the trench. Hence, there is certain overvoltage protection against spike voltages.

Although the introduction of the JFET structure increases the ON-resistance slightly, switching buffering and self-suppression on surge voltages are achieved.

The silicon carbide MOSFET device have improved self-suppression against the surge voltages and overvoltage, and is free of device damages and reliability reduction due to actual delays of overvoltage protection circuits and overcurrent protection circuits.

Moreover, spike jitters are buffered during switching, which reduces a switching loss. Fewer buffer circuits or buffer structures are required in circuit designs, which reduce a quantity of discrete components. Thereby, a cost and an actual volume of modules are reduced, which enhances reliability.

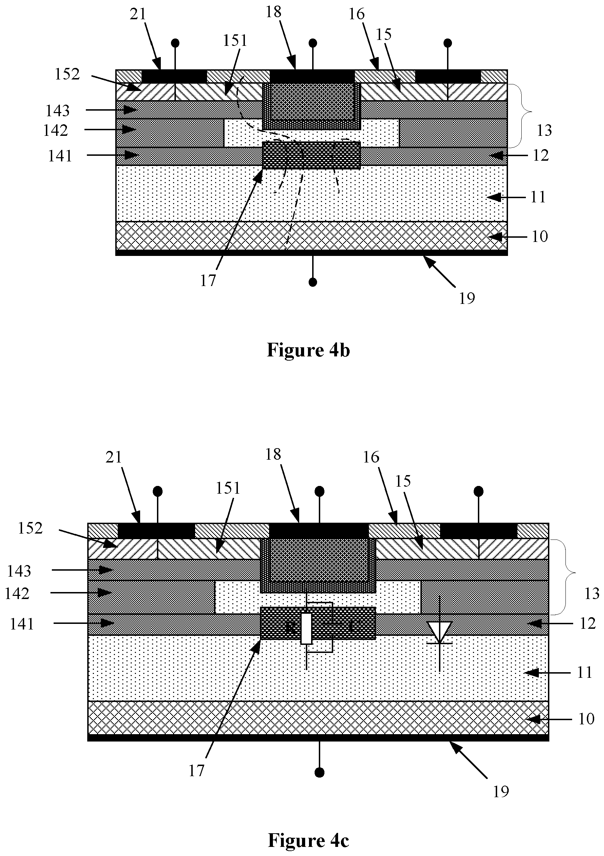

Reference is made to Figure 4b, which is a schematic diagram of a main current path of a silicon carbide MOSFET device as shown in Figure 4a when being switched on. A current path between the source electrode and the drain electrode is indicated by the middle dashed curve in Figure 4b. Current flows through the JFET structure established based on the doped region 17. A rapid change of the current would generate a high-frequency spike voltage in the circuit. Due to the simultaneously rapid change of a voltage on the current path, a depletion region of the JFET structure (i.e., a region between the left and right dashed curves in Figure 4b) expands or shrinks swiftly in correspondence to the voltage. In such case, the JFET structure is equivalent to a variable resistor R and a junction capacitor C which are connected in parallel. Reference is made to Figure 4c, which is a schematic diagram of equivalent parasitic parameters of a silicon carbide MOSFET device as shown in Figure 4b.

An appropriate thickness d and doping concentration of the second epitaxial layer 12, and a design of a pattern and a concentration for ion implantation of the doped region 17, may be selected, optimized, and adjusted based on a specific circuit environment and device simulation of electrical models. Thereby, appropriate parasitic parameters (such as resistance of the variable resistor R and capacitance of the junction capacitor C) can be obtained. The parasitic parameters are capable to suppress voltage spikes effectively and reduce a switching loss when applied in circuit modules having different switching frequencies in practice.

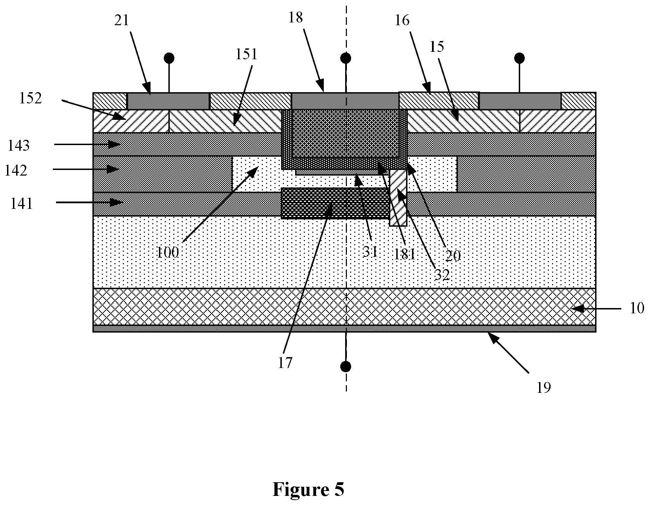

Voltage endurance at the bottom of the trench gate may be further improved on a basis of the silicon carbide MOSFET device as shown in Figure 4a. Reference is made to Figure 5, which is a schematic structure diagram of another silicon carbide MOSFET device according to an embodiment of the present disclosure. The silicon carbide MOSFET device comprises an epitaxial wafer, a well region, a source region 15, and a trench gate.

The epitaxial wafer comprises a semiconductor substrate 10 and epitaxial layers disposed on a surface of the semiconductor substrate 10.

The well region, the source region 15, and the trench gate are in the epitaxial layers.

The trench gate comprises a gate 18 disposed in a trench 20 at a surface of the epitaxial layers facing away from the semiconductor substrate. A gate dielectric layer 181 is disposed between the gate electrode and the trench.

The source region 15 surrounds the trench 20, and is in contact with sidewalls of the trench 20.

The well region comprises a first layer 141, a second layer 142, and a third layer 143, which are arranged in the above-listed sequence along a direction pointing from the semiconductor substrate 10 to the source region 15. A bottom of the trench 20 is disposed higher than the first layer 141 and lower than the third layer 143. The third layer 143 surrounds the 20 trench and is in contact with the sidewalls of the trench 20. Doped region(s) 17 are disposed in the epitaxial layers and beneath the trench 20. The first layer 141 surrounds each of the doped regions 17, and is in contact with such doped region 17. A part 100 of the epitaxial layers is disposed between the first layer 141 and the third layer 143, and the second layer 142 is disposed on two sides of the part 100 of the epitaxial layers. A shielding layer 31 is disposed in the part 100 of the epitaxial layers, and is configured to protect a bottom of the trench gate. The shielding layer 31 is disposed beneath the trench 20, and dopants in the shielding layer 31 has a same polarity as dopants in each of the first layer 141, the second layer 142, and the third layer 143. Each of the first layer 141, the second layer 142, and the third layer 143 may have dopants of the same polarity.

In one embodiment, dopants of each of the first layer 141, the second layer 142, and the third layer 143 may be identical in polarity and concentration. For example, each layer may be p doped. The shielding layer 31 may have the same doping concentration as each of the first layer 141, the second layer 142, and the third layer 143, i.e., may be p doped. Alternatively, the shielding layer 31 may have a doping concentration greater than that of each layer, e.g., may be p+ doped. In another embodiment, the first layer 141, the second layer 142, and the third layer 143 may have different doping concentration.

In the structure as shown in Figure 5, the shielding layer 31 disposed beneath the trench 20 is capable to protect the bottom of the trench gate and improve voltage endurance of the bottom of the trench gate.

Along a direction perpendicular to the semiconductor substrate 10, a distance between the shielding layer 31 and the bottom of the trench 20 may be smaller than a distance between the shielding layer 31 and the first layer 141. Thereby, the bottom of the trench gate can be protected more effectively. In an embodiment, the shielding layer 31 is in contact with the bottom of the trench 20, that is, the distance between the shielding layer 31 and the bottom of the trench 20 is zero.

In the structure as shown in Figure 5, a vertical projection of the doped region 17 on the semiconductor substrate 10 may be located within a vertical projection of the trench 20 on the semiconductor substrate 10. The vertical projection of the trench 20 on the semiconductor substrate 10 may be located within a vertical projection of the part 100 of the epitaxial layers on the semiconductor substrate 10, and a distance between boundaries of such two vertical projections is not zero. That is, two parts of the second layer 142 each is separated from a corresponding sidewall of the trench 20 by a non-zero distance, as shown in Figure 5.

As shown in Figure 5, a connection region 32 connecting the shielding layer 31 and the first layer 141 may be provided in the part 100 of the epitaxial layers. Dopants in the connection region 32 have the same polarity as those in each of the first layer 141, the second layer 142, and the third layer 143. The connection region 32 connects the shielding layer 31 and the first layer 141, and thereby the bottom of the trench gate is wrapped in a "capsule-shaped" structure which can achieve better protection on the bottom of the trench.

Since the connection region 32 is provided, the shielding layer 31 is connected to the third layer 143 via the connection region 32, thereby connected to the source region 15, and thus can be grounded via the source electrode 21. In one aspect, dynamic capture and accumulation of carriers due to a suspended potential of the shielding layer 31 are prevented during long-term dynamic switching operations, and hence it is prevented that the shielding layer 31 loses a protection function on the bottom of the trench gate gradually due to the dynamic capture and accumulation of carriers. In another aspect, it is prevented that parasitic capacitance of the gate is increased due to the suspended potential of the shielding layer 31, and hence it is prevented that switching loss is increased due to the parasitic capacitance.

Each of the first layer 141, the second layer 142, the third layer 143, the shielding layer 31, and the connection region 32 have dopants of the same polarity, and the doping concentration of the connection region 32 may be greater than the doping concentration of each of the first layer 141, the second layer 142, and the third layer 143. Thereby, resistance of the connection between the shielding layer 31 and the first layer 141 is reduced. For example, each of the first layer 141, the second layer 142, and the third layer 143 is p doped, and the connection region 32 is p+ doped.

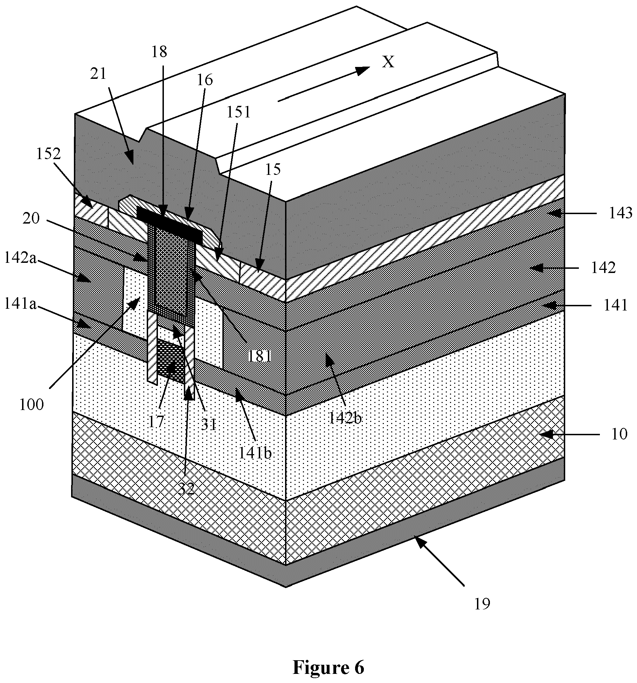

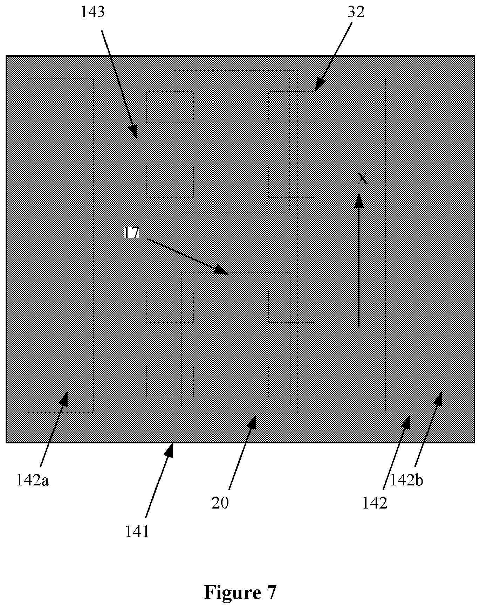

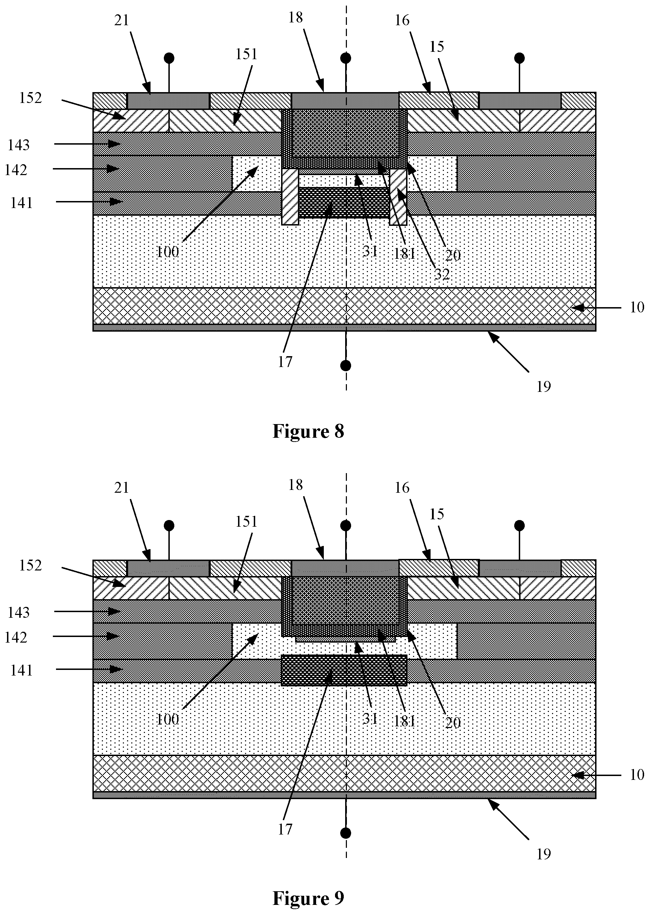

Reference is made to Figures 6 to 9. Figure 6 is a stereoscopic view of a silicon carbide MOSFET device according to an embodiment of the present disclosure. Figure 7 shows a top view of patterns for forming each layer of a well region, a trench, a doped region, and a connection region in a silicon carbide MOSFET device as shown in Figure 6. Figure 8 is a view of a silicon carbide MOSFET device as shown in Figure 6 in a first cross section perpendicular to the extending direction of the trench. Figure 9 is a view of a silicon carbide MOSFET device as shown in Figure 6 in a second cross section perpendicular to the extending direction of the trench. The cross section as shown in Figure 8 intersects two connection regions 32 on opposite sides of the doped region 17. The cross section in Figure 9 intersects an interval between two connection regions 32 which are adjacent along the first direction X.

As shown in Figure 6, the first layer 141 comprises a first part 141a and a second part 141b, which are located on two sides, respectively, of the trench 20. The first part 141a is connected to the shielding layer 31 via at least one connection region 32, and/or the second part 141b is connected to the shielding layer 31 via at least one connection region 32.

In order to improve reliability and stability of connection and reduce impedance of the connection, the first part 141a is connected to the shielding layer 31 via multiple connection regions 32 arranged sequentially along a first direction X, as shown in Figures 6 and 7. Additionally or alternatively, the second part 141b is connected to the shielding layer 31 via multiple connection regions 32 arranged sequentially along the first direction X. The first direction X is parallel with the semiconductor substrate 10, and is parallel with an extending direction of the trench 20.

At least one doped region 17 may be disposed beneath the trench 20. In a case that there are multiple doped regions 17 below the trench 20, the doped regions 17 may be disposed sequentially along the first direction X. A quantity of the doped regions 17 may be, but is not limited to, two as shown in Figure 7, and may be configured as any number on requirement. In order to ensure a protection effect on the bottom of the trench gate, the shielding layer 31 may be of an integral structure located below the trench 20, and may extend from one end of the trench 20 to another end of the trench 20.

As shown in Figures 6 and 7, the second layer 142 may comprises a first part of the second layer and a second part of the second layer, and the first part and the second layer are located at two sides, respectively, of the trench 20. The first part of the second layer and the second part of the second layer each may be of an integrated structure.

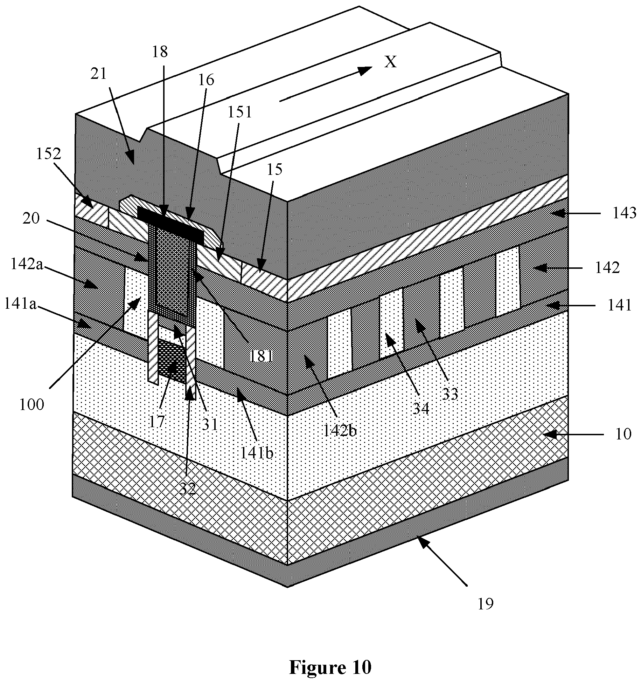

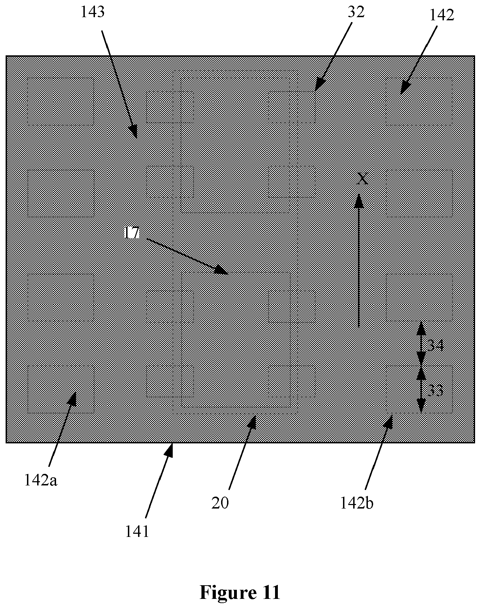

Reference is made to Figures 10 and 11. Figure 10 is a stereoscopic view of another silicon carbide MOSFET device according to an embodiment of the present disclosure. Figure 11 is a top view of patterns for forming each layer of a well region, a trench, a doped region, and a connection region in a silicon carbide MOSFET device as shown in Figure 10. In such structure, the second layer 142 comprises a first part 142a and a second part 142b located on two sides, respectively, of the trench 20. The first part 142a and the second part 142b each comprises multiple sub-regions 33 arranged sequentially along the first direction X. A current expanding region 34 is disposed between each pair of sub-regions 33 adjacent along the first direction X, and dopants of the current expanding region 34 have an opposite polarity to those of the sub-regions 33. The part 100 of the epitaxial layers comprises the current expanding region(s) 34.

As an example, the first layer 141 is p doped. When the first layer 141 is inverted to form an n-channel, a current expands to a boundary of the second layer 142. The current expansion area 34 between each pair of adjacent sub-regions 33 in the second layer 142 is capable to expand the current, thereby reducing resistance and a current loss.

Herein each connection region 32 may extend at least from the bottom of the trench 20 into the first layer 141. In such case, the trench 20 occludes the connection region(s) 32 completely when viewing along a direction perpendicular to the semiconductor substrate 10.

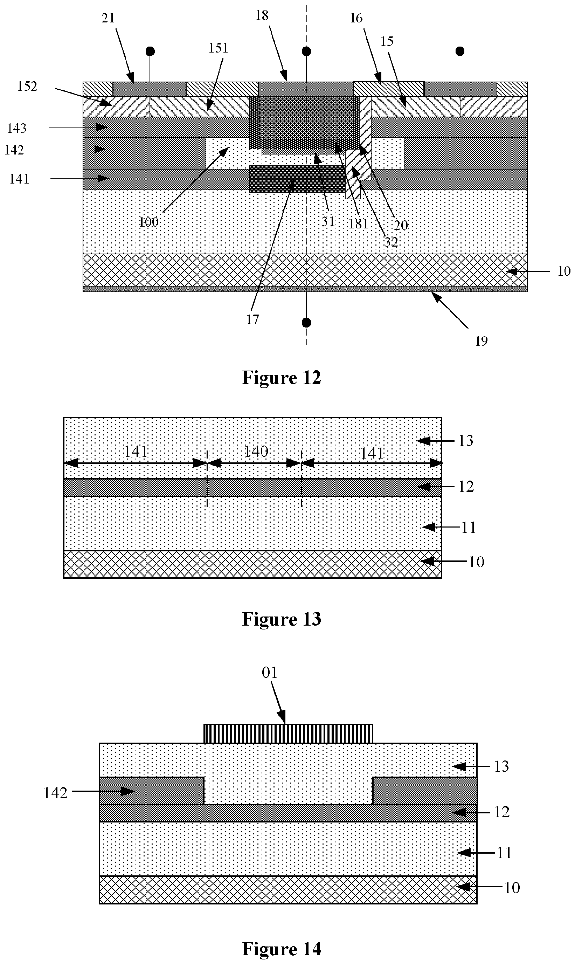

Reference is made to Figure 12, which is a schematic structural diagram of another silicon carbide MOSFET device according to an embodiment of the present disclosure. The structure as shown in Figure 12 is based on the foregoing embodiments. A part of the connection region 32 extends at least from the bottom of the trench 20 into the first layer 141, and another part of the connection region 32 extends at least from a surface of the epitaxial layer, along a corresponding sidewall of the trench 20, into the first layer 141. In such case, the trench 20 blocks the part of the connection region 32. Such structure can provide a better connection between the shielding layer 31 and the source region 15, and an impedance of the connection is reduced.

In an embodiment, the connection region 32 is formed by performing ion implantation on the trench 20, and a region for the ion implantation is located within the trench 20 and does not overlap with the sidewalls of the trench 20. Hence, the whole connection region 32 is located beneath the trench 20. In a case that the region for ion implantation region is close to a sidewall of the trench 20 and has an incident angle not parallel with the sidewall, the structure as shown in Figure 12 is formed.

Herein a bottom of the connection region 32 extends at least into the first layer 141, and may extend further to run through the first layer 141.

Herein a structure of only one cell of a MOSFET device is shown in the drawings. In practice, the MOSFET device may comprise multiple cells. A quantity and a layout of the cells may be configured on requirement, and are not specifically limited herein.

In the silicon carbide MOSFET device, a thickness of a third epitaxial layer 13 may not exceed 1µm, such that a depth of ion implantation depth for forming the second layer 142 and the third layer 143 does not exceed 1µm. Hence, the second layer 142 and the third layer 143 can be formed in the third epitaxial layer 13 through ion implantation without introducing lattice damages.

Herein the distance between the bottom of the trench 20 and the first epitaxial layer 11 may be less than 1µm. Thereby, when the doped region 17 is formed by performing ion implantation on the trench, a depth of the ion implantation for the doped region 17 is less than 1µm. The doped region 17 can be formed in a second epitaxial layer 12 through ion implantation without introducing lattice damages. A distance between the doped region 17 and the bottom of the trench is not zero.

In the drawings, a width of the trench 20 satisfies a uniform condition along a direction pointing from the bottom of the trench 20 points toward an opening of the trench 20. That is, the width of the trench may be constant or substantially constant along such direction, i.e., the trench 20 may be a rectangular trench. Generally, the second epitaxial layer 12 is an epitaxial layer with a uniform thickness, and the width of the trench meeting the uniform condition facilitates forming the doped region 17 having a uniform width along such direction.

In another embodiment, the width of the trench 20 may be gradually increased along the direction pointing from the bottom of the trench points toward the opening of the trench. That is, the trench may be a V-shaped trench or an inverted-trapezoidal trench. In case of the V-shaped trench, the doped region 17 has a V-shaped structure. In a case of the inverted-trapezoidal trench, the doped region has an inverted-trapezoidal structure when the a window for ion implantation is larger than the bottom of the trench, as shown in Figure 11, and has a rectangular structure when the window for ion implantation is not larger than the bottom of the trench.

Here the width of the doped region 17 may be no larger than the width of the trench. Thereby, the doped region 17 can be formed by performing ion implantation on the trench, and a depth of ion implantation can be reduced.

A doping concentration of the doped region 17 is greater than that of the first epitaxial layer 11 and that of the third epitaxial layer 13. For example, the doped region 17 is n+ doped, and the first epitaxial layer 11 and the third epitaxial layer 13 are n- doped.

The semiconductor substrate 10 may an n+ doped substrate, the second epitaxial layer 12 may p- type doped, and the doped region 17 is n- doped. Herein a relationship of doping concentration is n+ > n > n- and p+ > p > p-. Dopants of n-, n, and n+ doping are identical in polarity, which may be called first polarity. Dopants of p-, p, and p+ doping are identical in polarity, which may be called second polarity. The first polarity and the second polarity are opposite polarities.

The silicon carbide MOSFET device may be an NMOS or a PMOS. A polarity of dopants in each region may be configured on requirement to form the NMOS or the PMOS.

On a basis of the foregoing embodiments, a method for manufacturing a silicon carbide MOSFET device is further provided according to an embodiment of the present disclosure. Accordingly, the silicon carbide MOSFET device in the foregoing embodiments can be manufactured. Reference are made to Figures 13 to 19, which are schematic diagrams in a process of a method for manufacturing a silicon carbide MOSFET device according to an embodiment of the present disclosure. The method comprises steps S 11 and S12.

In step S11, an epitaxial wafer is provided, as shown in Figure 13. The epitaxial wafer comprises a semiconductor substrate 10 and epitaxial layers disposed on a surface of the semiconductor substrate 10.

The epitaxial wafer may be a silicon carbide epitaxial wafer. The semiconductor substrate 10 and each epitaxial layer on its surface may be made of silicon carbide.

In step S12, a well region, a source region 15, and a trench gate are formed in the epitaxial layers, as shown in any one of Figures 5 to 12.

The trench gate comprises a gate disposed in a trench 20 at a surface of the epitaxial layers facing away from the semiconductor substrate 10. A gate dielectric layer 181 is disposed between the gate electrode and the trench 20.

The source region 15 surrounds the trench 20 and is in contact with sidewalls of the trench 20.

The well region comprises a first layer 141, a second layer 142, and a third layer 143, which are arranged in the above-listed sequence along a direction pointing from the semiconductor substrate 10 to the source region 15. A bottom of the trench 20 is higher than the first layer 141 and lower than the third layer 143. The third layer 143 surrounds the trench 20 and is in contact with the sidewalls of the trench 20. One or more doped regions 17 are disposed in the epitaxial layers and beneath the trench 20. The first layer 141 surrounds each of the one or more doped regions 17, and is in contact with such doped region 17. A part 100 of the epitaxial layers is disposed between the first layer 141 and the third layer 143, and the second layer 142 is disposed on two sides of the part 100 of the epitaxial layers. A shielding layer 31 is disposed in the part 100 of the epitaxial layers, and is configured to protect a bottom of the trench gate. The shielding layer 31 is disposed beneath the trench 20, and dopants in the shielding layer 31 has a same polarity as dopants in each of the first layer 141, the second layer 142, and the third layer 143.

As shown in Figure 13, the epitaxial layers comprises a first epitaxial layer 11 disposed on the surface of the semiconductor substrate 10, a second epitaxial layer 12 disposed on a surface of the first epitaxial layer 11 facing away from the semiconductor substrate 10, and a third epitaxial layer 13 disposed on a surface of the second epitaxial layer 12 facing away from the first epitaxial layer 11. The second epitaxial layer 12 has a to-be-implanted region 140 and the first layer 141, and the first layer 141 surrounds the to-be-implanted region 140.

In the MOSFET device, the well region structure comprises the first layer 141, the second layer 142, and the third layer 143. The second epitaxial layer 12 has the to-be-implanted region and the first layer 141 surrounding the to-be-implanted region. The to-be-implanted region 140 is configured to form the doped region 17.

In the method, the epitaxial wafer may be formed through following steps. The first epitaxial layer 11, the second epitaxial layer 12, and the third epitaxial layer 13 are formed through epitaxy in the above-listed sequence on the surface of the semiconductor substrate 10. Dopants in the first epitaxial layer 11 and dopants in the third epitaxial layer 13 have the same polarity, and dopants in the second epitaxial layer 12 have an opposite polarity to those in the first epitaxial layer 11 and those in the third epitaxial layer 13.

As an example, the semiconductor substrate 10 may be an n+ doped silicon carbide substrate, the first epitaxial layer 11 and the third epitaxial layer 13 are both n- doped silicon carbide epitaxial layers, and the second epitaxial layer 12 is a p doped silicon carbide epitaxial layer. In such case, the p doped second epitaxial layer 12 serves as a buried layer. Hence, the doped region 17 is formed by performing ion implantation on the trench 20, which is required by the gate electrode 18, in the epitaxial wafer having the buried layer. Hence, shielding of the trench gate structure is achieved, and a process of ion injection into the silicon carbide is less difficult. Moreover, the doped region 17 can form a JFET structure, which can be modulated, in a current path of the MOSFET device. Thereby, device resistance and self-locking protection can be automatically adjusted while ensuring a small cell of the MOSFET device.

In the above step S12, forming the well region, the source region 15, and the trench gate in the epitaxial layers comprises steps S121 to S125.

In step S121, the source region, the second layer, and the third layer are formed in a surface of the third epitaxial layer facing away from the semiconductor substrate, as shown in Figures 14 to 16.

In such step, the second layer 142, the third layer 143 and the source region 15 are sequentially formed in the third epitaxial layer 13 through ion implantation. The second layer 142 is located between the first layer 141 and the third layer 143. The source region 15 is located on a side of the third layer 143 away from the second layer 142.

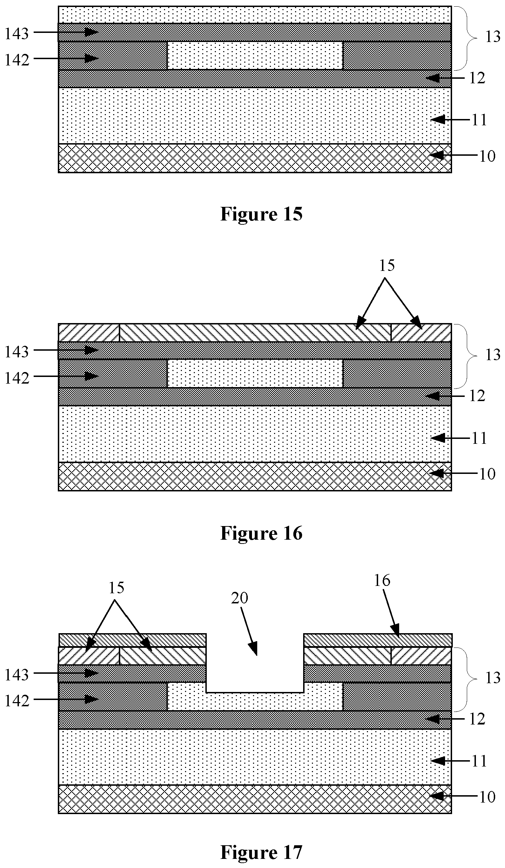

In an embodiment, the second layer 142 is formed in the third epitaxial layer 13 through ion implantation by using a mask layer 01, as shown in Figure 14. The second layer 142 surrounds a non-implantation region, which comprises the aforementioned part 100 of the epitaxial layers. The non-implantation region as required is formed based on the mask layer 01 which forms a pattern. Vertical projections of the trench 20 and the doped region 17 each is within the non-implanted region, and has a non-zero distance from a boundary of the non-implanted region along a direction parallel with the epitaxial wafer (i.e., the horizontal direction in Figure 14). Afterwards, as shown in Figure 15, a third layer 143 is formed on the second layer 142 through another process of ion implantation. The third layer 143 covers the second layer 142 and the non-implantation region surrounded by the second layer 142. Afterwards, as shown in Figure 16, the source region 15 is formed on the third layer 143 through another process of ion implantation.

In step S122, the trench 20 is formed in the surface of the third epitaxial layer facing away from the semiconductor substrate, as shown in Figure 17. The bottom of the trench 20 is higher than the second epitaxial layer 12 and lower than the third layer 143.

The source region 15 and the third layer 143 may be in contact with the sidewalls of the trench 20. When forming the source region 15 through ion implantation, a region of the ion implantation covers a region for forming the trench 20. Hence, after the trench is subsequently formed, the source region 15 that remains is in direct contact with the sidewalls of the trench 20. Similarly, when forming the third layer 143 through ion implantation, a region of the ion implantation covers the region for forming the trench 20. Hence, after the trench is subsequently formed, the third layer 143 that remains s is in direct contact with the sidewalls of the trench 20.

There is a distance between the second layer 142 and the sidewall(s) of the trench 20. A size of the non-implantation region surrounded by the second layer 142 is set larger than a size of the trench 20. The vertical projection of the trench 20 is located within the non-implantation region, and there is a distance between such vertical projection and a boundary of the non-implantation region. Thereby, the second layer 142 is not in contact with the sidewall(s) of the trench 20, that is, there is a gap between the two.

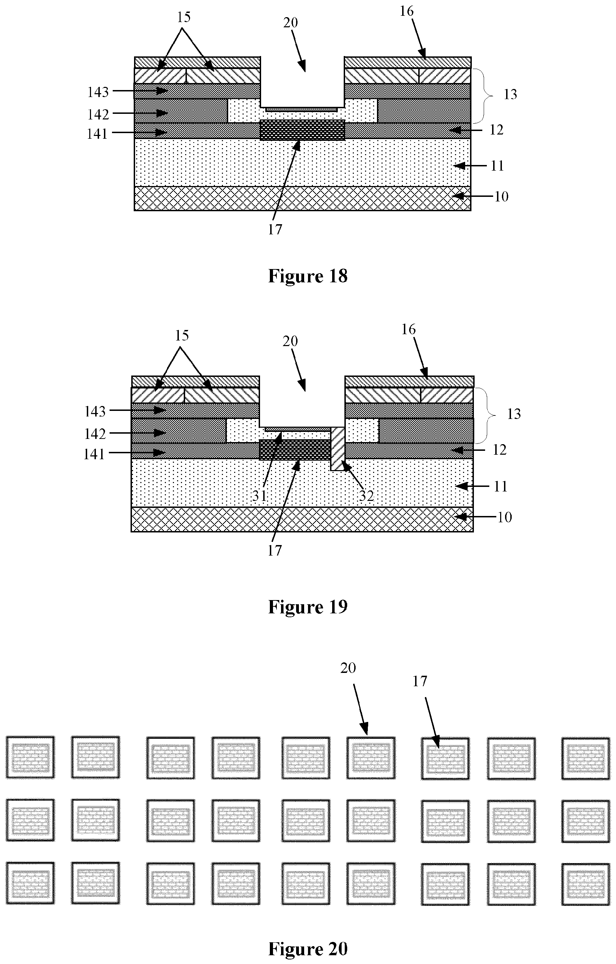

In step S123, the shielding layer 31 and the doped region 17 are formed through the trench, as shown in Figure 18.

Dopants in the doped region 17 have the same polarity as those in the first epitaxial layer 11 and those in the third epitaxial layer 13.

Ion implantation is performed on the trench 20, so as to form the shielding layer 31 and the doped region 17 which meet quality requirements at a large depth in the epitaxial layers. The first layer 141 is one of the epitaxial layers, and hence the first layer 141 as required can be formed at a large depth in the epitaxial layers without ion implantation. The doped region 17 runs through the second epitaxial layer 12.

In step S124, a connection region 32, which connects the shielding layer 31 and the first layer 141, is formed through the trench 20, as shown in Figure 19.

The connection region 32 may be formed through ion implantation. Ion implantation is performed on the trench 20, so as to form the connection region 32 is which meet quality requirement at a large depth in the epitaxial layers.

In step S125, the gate dielectric layer 181 and the gate 18 are formed in the trench. Thereby, the silicon carbide MOSFET device in the foregoing embodiments is formed.

The gate 18 comprises a filling dielectric, which fills the trench 20, and a metallic gate electrode disposed on a surface of the filling dielectric. The gate dielectric layer 181 is located on the surface of the trench 20. The gate 18 is formed in the trench 20 after the gate dielectric layer 181 is formed. The gate dielectric layer 181 may be polysilicon or the like. The doped region 17 is formed before the gate dielectric layer 181 is formed in the trench 20.

In an embodiment, the method further comprises following steps. A metallic source electrode 21 connecting the source region 15 is formed. A metallic drain electrode 19 is formed on a surface of the semiconductor substrate 10 away from the first epitaxial layer 11. The source region 15 comprises a first region 151 and a second region 152, which have dopants of opposite polarities. The metal source electrode 21 is in contact with both the first region 151 and the second region 152. The first region 151 may be n+ doped, and the second region 152 may be p+ doped.

Reference is made to Figure 20, which is a pattern for forming a trench and an area of ion implantation for forming a doped region of a silicon carbide MOSFET device according to an embodiment of the present disclosure. A window for ion implantation for forming the doped region 17 is located within in the trench 20. Channel characteristics of the JFET structure may be adjusted based on a design of a pattern, concentration of ion implantation, and a profile of the pattern, which are of the doped region 17. An area of the window for ion implantation for forming the doped region 17 may be smaller than or equal to an area of the trench 20.

Herein the silicon carbide MOSFET device is illustrated based on only a single cell. When manufacturing the MOSFET device, multiple unit cells may be simultaneously fabricated in a wafer-level process, and then the wafer is divided to form the silicon carbide MOSFET device(s). The silicon carbide MOSFET device may comprise multiple unit cells.

The embodiments of the present disclosure are described in a progressive manner, a parallel manner, or a combination of the two. Each embodiment places emphasis on the difference from other embodiments. Therefore, one embodiment can refer to other embodiments for the same or similar parts.

Herein terms indicating orientation or a positional relationship, such as "up", "low", "top", "bottom", "inner", "outer", and the like, are based on the orientation or the positional relationship as shown in the drawings. These terms are only intended for facilitating and simplifying description of the present disclosure, and do not explicitly or implicitly indicate that concerning devices or elements must have a specific orientation or must be constructed and operated based on a specific orientation. Therefore, the orientation or the positional relationship shall not be construed as a limitation on the present disclosure. In a case that a component is described to be "connected" to another component, it may be connected directly to the other component, or there may be an intermediate component between the two.

It should be noted that, the relationship terms such as "first", "second" and the like are only used herein to distinguish one entity or operation from another, rather than to necessitate or imply that an actual relationship or order exists between the entities or operations. Furthermore, the terms such as "include", "comprise" or any other variants thereof means to be non-exclusive. Therefore, a process, a method, an article or a device including a series of elements include not only the disclosed elements but also other elements that are not clearly enumerated, or further include inherent elements of the process, the method, the article or the device. Unless expressively limited, the statement "including a... " does not exclude the case that other similar elements may exist in the process, the method, the article or the device other than enumerated elements. According to the description of the disclosed embodiments, those skilled in the art can implement or use the present disclosure. Various modifications made to these embodiments may be obvious to those skilled in the art, and the general principle defined herein may be implemented in other embodiments without departing from the spirit or scope of the present disclosure. Therefore, the present disclosure is not limited to the embodiments described herein but conforms to a widest scope in accordance with principles and novel features disclosed in the present disclosure.

## Claims

1. A silicon carbide MOSFET device, comprising:
an epitaxial wafer, which comprises a semiconductor substrate and epitaxial layers disposed on a surface of the semiconductor substrate; and
a well region, a source region, and a trench gate, which are in the epitaxial layers, wherein:
the trench gate comprises a gate disposed in a trench at a surface of the epitaxial layers facing away from the semiconductor substrate, and a gate dielectric layer is disposed between the gate electrode and the trench;
the source region surrounds the trench and is in contact with sidewalls of the trench;
the well region comprises a first layer, a second layer, and a third layer, which are arranged in the above-listed sequence along a direction pointing from the semiconductor substrate to the source region;
a bottom of the trench is disposed higher than the first layer and lower than the third layer;
the third layer surrounds the trench and is in contact with the sidewalls of the trench;
one or more doped regions are disposed in the epitaxial layers and beneath the trench, and the first layer surrounds each of the one or more doped region and is in contact with said doped region;
a part of the epitaxial layers is disposed between the first layer and the third layer, and the second layer is disposed on two sides of the part of the epitaxial layers;
a shielding layer is disposed in the part of the epitaxial layers and is configured to protect a bottom of the trench gate; and
the shielding layer is disposed beneath the trench, and dopants in the shielding layer has a same polarity as dopants in each of the first layer, the second layer, and the third layer.

2. The silicon carbide MOSFET device according to claim 1, wherein:
a vertical projection of the one or more doped regions on the semiconductor substrate is located within a vertical projection of the trench on the semiconductor substrate, and the vertical projection of the trench on the semiconductor substrate is located within a vertical projection of the part of the epitaxial layers on the semiconductor substrate; and
there is a non-zero distance between a boundary of the vertical projection of the trench and a boundary of the vertical projection of the part of the epitaxial layers.

3. The silicon carbide MOSFET device according to claim 1, wherein:
one or more connection regions, which connect the shielding layer and the first layer, are disposed in the part of the epitaxial layers, and
dopants in each of the one or more connection region has the same polarity as the dopants in each of the first layer, the second layer, and the third layer.

4. The silicon carbide MOSFET device according to claim 3, wherein the first layer comprises a first part and a second part, which are disposed at two sides, respectively, of the trench, wherein:
the one or more connection regions are a plurality of connection regions arranged sequentially along a first direction, which is parallel with the semiconductor substrate and parallel with an extending direction of the trench, and
one or both of the first part and the second part are connected to the shielding layer via the plurality of connection regions.

5. The silicon carbide MOSFET device according to claim 1, wherein the one or more doped regions are a plurality of doped regions arranged sequentially along a first direction, which is parallel with the semiconductor substrate and parallel with an extending direction of the trench.

6. The silicon carbide MOSFET device according to claim 1, wherein along a direction perpendicular to the semiconductor substrate, a distance from the shielding layer to the bottom of the trench is smaller than a distance from the shielding layer to the first layer.

7. The silicon carbide MOSFET device according to claim 6, wherein the shielding layer is in contact with the bottom of the trench.

8. The silicon carbide MOSFET device according to claim 1, wherein:
the second layer comprises a first part and a second part, which are disposed on two sides, respectively, of the trench; and
the first part and the second part each is an integral structure.

9. The silicon carbide MOSFET device according to claim 1, wherein:
the second layer comprises a first part and a second part, which are disposed on two sides, respectively, of the trench;
the first part of the second layer and the second part each comprises a plurality of sub-regions arranged sequentially along a first direction, which is parallel with the semiconductor substrate and parallel with an extending direction of the trench; and
a current expanding region is disposed between each pair of sub-regions which are adjacent along the first direction among the plurality sub-regions, and dopants in the current expanding region has an opposite polarity to dopants in the a plurality of sub-regions.

10. The silicon carbide MOSFET device according to claim 3, wherein:
a polarity of dopants are identical among the first layer, the second layer, the third layer, the shielding layer, and the one or more connection regions, and
a doping concentration of the one or more connection regions is greater than a doping concentration of each of the first layer, the second layer, and the third layer.

11. The silicon carbide MOSFET device according to claim 3, wherein:
each of the one or more connection regions extends at least from the bottom of the trench into the first layer; or
a part of each of the one or more connection regions extends at least from the bottom of the trench into the first layer, and another part of said connection region extends at least from the surface of the epitaxial layers into the first layer along one of the sidewalls of the trench.

12. A method for manufacturing the silicon carbide MOSFET device according to any one of claims 1 to 11, comprising:
providing an epitaxial wafer, which comprises a semiconductor substrate and epitaxial layers disposed on a surface of the semiconductor substrate;
forming a well region, a source region and a trench gate in the epitaxial layers, wherein:
the trench gate comprises a gate disposed in a trench at a surface of the epitaxial layers facing away from the semiconductor substrate, and a gate dielectric layer is disposed between the gate electrode and the trench;
the source region surrounds the trench and is in contact with sidewalls of the trench;
the well region comprises a first layer, a second layer, and a third layer, which are arranged in the above-listed sequence along a direction pointing from the semiconductor substrate to the source region;
a bottom of the trench is higher than the first layer and lower than the third layer;
the third layer surrounds the trench and is in contact with the sidewalls of the trench;
one or more doped regions are disposed in the epitaxial layers and beneath the trench, and the first layer surrounds each of the one or more doped region and is in contact with said doped region;
a part of the epitaxial layers is disposed between the first layer and the third layer, and the second layer is disposed on two sides of the part of the epitaxial layers;
a shielding layer is disposed in the part of the epitaxial layers and is configured to protect a bottom of the trench gate; and
the shielding layer is disposed beneath the trench, and dopants in the shielding layer has a same polarity as dopants in each of the first layer, the second layer, and the third layer.

13. The method according to claim 12, wherein:
the epitaxial layers comprises:
a first epitaxial layer disposed on the surface of the semiconductor substrate;
a second epitaxial layer disposed on a surface of the first epitaxial layer facing away from the semiconductor substrate; and
a third epitaxial layer on a surface of the second epitaxial layer facing away from the first epitaxial layer; and
the second epitaxial layer comprises a to-be-implanted region and the first layer which surrounds the to-be-implanted region; and
forming the well region, the source region, and the trench gate in the epitaxial layers comprises:
forming the source region, the second layer, and the third layer in a surface of the third epitaxial layer facing away from the semiconductor substrate;
forming the trench in the surface of the third epitaxial layer facing away from the semiconductor substrate;
forming the shielding layer and the doped region through the trench;
forming a connection region, which connects the shielding layer and the first layer, through the trench; and
forming the gate dielectric layer and the gate in the trench.
